# EUROPEAN PATENT SPECIFICATION

(11) **EP 0 527 029 B1**
(45) Date of publication and mention of the grant of the patent: **14.05.1997**
(21) Application number: 92307105.4
(22) Date of filing: 04.08.1992
(51) Int. Cl.: H03G 3/20

(54) **Power control circuit and a method of controlling a power amplifier**
Leistungsregelungsschaltung und Verfahren zur Regelung der Leistung eines Verstärkers
Circuit de contrôle de puissance et méthode de contrôle d'un amplificateur de puissance

(30) Priority: 05.08.1991 JP 194610/91
(43) Date of publication of application: 10.02.1993
(73) Proprietor: NEC CORPORATION, Tokyo (JP)
(72) Inventor: Miyashita, Toshikazu, c/o NEC Corporation, Minato-ku, Tokyo 108-01 (JP)
(74) Representative: Harland, Linda Jane

(56) References cited:
- EP-A- 0 135 154
- EP-A- 0 261 967
- GB-A- 2 238 435

## Description

### BACKGROUND OF THE INVENTION

### 1. Field of the Invention

The present invention relates to a Power control circuit for controlling the output level of a power amplifier and a method of controlling the power amplifier.

### 2. Description of the prior art

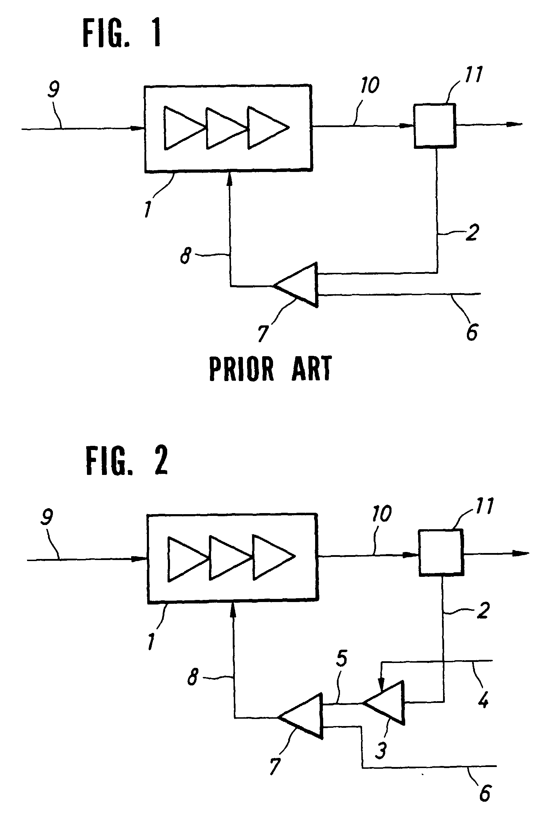

Power control circuits for amplifying electrical power are known. Fig. 1 shows a conventionally known power control circuit wherein a power module 1 amplifies the power of a transmission signal 9, and its output level is controlled by a control signal 8. A detector 11 detects an output signal 10 from the power module 1 and outputs a signal 2 representing the level of the output signal 10. A differential arithmetic unit 7 supplies a value obtained by subtracting the output signal 2 of the detector 11 from a reference voltage 6 to the power module 1 as the control signal 8. With the above arrangement, when the amplitude of the output signal 10 is excessively large, since the level of the signal 2 is large so as to decrease the value of the control signal 8, the output level of the power module 1 is decreased. In contrast to this, when the output level of the power module 1 is excessively small, since the control signal 8 having a large value is supplied to the power module 1, the power module 1 increases the output level. That is, the power module 1 is controlled to be set at an output level corresponding to the reference voltage 6. In this manner, in the conventional power control circuit, the output level of the power module 1 is determined by the reference voltage 6. For this reason, in order to obtain a required output level, a reference voltage corresponding to the required output level must be generated and supplied to the differential arithmetic unit 7. However, when the reference voltage is changed according to the output signal 2 from the detector 11, the differential arithmetic unit 7 may not be stably operated.

### SUMMARY OF THE INVENTION

It is an object of the present invention to provide a power control circuit capable of removing the above drawback and arbitrarily and stably setting an output level of a power amplifier while keeping a reference voltage constant.

It is another object of the present invention to provide a method of controlling the output level of a power amplifier which is capable of obtaining a stable output level.

In order to achieve the above object, according to the present invention, there is provided a power control circuit for a power amplifier having an output level controlled by a predetermined control signal, comprising a detector for detecting an output signal from the power amplifier, a variable gain amplifier for amplifying an output signal from the detector, and an arithmetic unit for receiving an output signal from the variable gain amplifier and a predetermined reference voltage as inputs and supplying a signal representing a difference between the output signal and the reference voltage to the power amplifier as the control signal.

### BRIEF DESCRIPTION OF THE ACCOMPANYING DRAWINGS

Fig. 1 is a block diagram showing a conventional power control circuit; and
Fig. 2 is a block diagram showing a power control circuit according to the present invention.

### DETAILED DESCRIPTION OF THE PREFERRED EMBODIMENT

An embodiment of the present invention will be described below with reference to the accompanying drawing. Fig. 2 shows a power control circuit according to the present invention. In Fig. 2, reference numeral 1 denotes a power module for amplifying the power of a transmission signal 9. The output level of the power module 1 is controlled by a control signal 8. A detector 11 detects an output signal 10 from the power module 1 and outputs a signal 2 representing the level of the output signal 10. A variable amplifier 3 amplifies the signal 2 according to a gain corresponding to a gain control signal 4. A differential arithmetic unit 7 supplies a value obtained by subtracting an output signal 5 of an amplifier 3 from a reference voltage 6 to the power module 1 as the control signal 8.

With the above arrangement, for example, when the amplitude of the output signal 10 is excessively large, the level of the output signal 2 from the detector 11 is large, and the amplifier 3 outputs the signal 5 having a large amplitude. Therefore, the arithmetic unit 7 outputs a control signal having a small value. As a result, the output level of the power module 1 is decreased. In contrast to this, when the output level is excessively small, since the arithmetic unit 7 outputs the control signal 8 having a large value, the power module 1 increases the output level. In this manner, the power module 1 is controlled to have the output level corresponding to the reference voltage 6.

In this power control circuit, when the output level of the power module 1 is to be increased, the value of the control signal 4 is decreased. As a result, the gain of the amplifier 3 is decreased, and the amplitude of the output signal 5 is decreased. For this reason, the arithmetic unit 7 outputs the control signal 8 having a large value, and the output level of the power module 1 is increased. On the other hand, when the output level of the power module 1 is to be decreased, the value of the control signal 4 is increased. As a result, the gain of the amplifier 3 is increased, and the amplitude of the output signal 5 is increased. For this reason, the arithmetic unit 7 outputs the control signal 8 having a small value, and the output level of the power module 1 is decreased. That is, in this power control circuit, the output level of the power module 1 can be arbitrarily set by the control signal 4 without changing the reference voltage 6.

As described above, in the power control circuit of the present invention, the level of the output signal from the detector to the differential arithmetic unit is changed by changing the gain of the variable gain amplifier. As a result, since the value of the control signal supplied to the power amplifier is changed, the output level of the power amplifier can be arbitrarily set without changing the reference voltage.

According to the present invention, the reference voltage 6 is constant, and the output signal 5 serving as an input to the differential arithmetic unit 7 is controlled by the variable amplifier 3 to have an almost constant value. Therefore, since the operation of the differential arithmetic unit 7 is stable, a power control operation can be stably performed.

## Claims

1. A power control circuit for a power amplifier (1) having an output level controlled by a given control signal, comprising:
a detector (11) for detecting an output from said power amplifier;
a variable gain amplifier (3) for amplifying an output signal from said detector; and
an arithmetic unit (7) for receiving an output signal from said variable gain amplifier and a predetermined reference voltage as inputs and supplying a signal representing a difference between the output signal and the reference voltage to said power amplifier as the control signal.

2. A circuit according to claim 1, wherein said power amplifier comprises a power module.

3. A circuit according to claim 1, wherein said variable gain amplifier changes a gain thereof on the basis of the given control signal.

4. An amplifier arrangement comprising:
power amplifier means (1) for amplifying a transmission signal and changing the output level thereof in response to a first control signal;
means (11) for detecting the output level of said power amplifier means to produce a detect signal;
variable amplifier means (3) for amplifying said detect signal and changing the output level thereof in response to a second control signal; and
means (7) for comparing the output level of said variable amplifier means with a reference voltage to produce a comparison signal representative of a level difference therebetween and supplying said comparison signal to said power amplifier means as said first control signal.

5. A method of controlling an output level of a power amplifier, comprising the steps of;
detecting said output level to produce a detect signal;
changing the level of said detect signal in response to a gain control signal;
comparing the changed level with a reference level to produce a level difference signal; and
controlling the gain of said power amplifier in response to said level difference signal.

## Patentansprüche

1. Leistungsregelungsschaltung für einen Leistungsverstärker (1) mit einem Ausgangspegel, der von einem gegebenen Steuersignal geregelt wird, mit:
einem Detektor (11) zum Ermitteln eines Ausgangssignals des Leistungsverstärkers;
einem Regelverstärker (3) zum Verstärken eines Ausgangssignals des Detektors; und
einer Recheneinheit (7) zum Empfangen eines Ausgangssignals des Regelverstärkers und einer vorbestimmten Referenzspannung als Eingangssignale und zum Liefern eines Signals, das eine Differenz zwischen dem Ausgangssignal und der Referenzspannung darstellt, als Steuersignal an den Leistungsverstärker.

2. Schaltung gemäß Anspruch 1, wobei der Leistungsverstärker ein Leistungsmodul aufweist.

3. Schaltung gemäß Anspruch 1, wobei der Regelverstärker seine Verstärkung auf der Grundlage des gegebenen Steuersignals ändert.

4. Verstärkeranordnung mit:
einer Leistungsverstärkereinrichtung (1) zum Verstärken eines Übertragungssignals und zum Ändern seines Ausgangspegels als Antwort auf ein erstes Steuersignal;
einer Einrichtung (11) zum Ermitteln des Ausgangspegels der Leistungsverstärkereinrichtung, um ein Ermittlungssignal zu erzeugen;
einer Regelverstärkereinrichtung (3) zum Verstärken des Ermittlungssignals und zum Ändern seines Ausgangspegels als Antwort auf ein zweites Steuersignal; und
einer Einrichtung (7) zum Vergleichen des Ausgangspegels der Regelverstärkereinrichtung mit einer Referenzspannung, um ein Vergleichssignal zu erzeugen, das eine Pegeldifferenz zwischen diesen darstellt, und zum Liefern des Vergleichssignals an die Leistungsverstärkereinrichtung als das erste Steuersignal.

5. Verfahren zur Regelung eines Ausgangspegels eines Leistungsverstärkers, mit den Schritten:
Ermitteln des Ausgangspegels, um ein Ermittlungssignal zu erzeugen;
Ändern des Pegels des Ermittlungssignals als Antwort auf ein Verstärkungssteuersignal;
Vergleichen des geänderten Pegels mit einem Referenzpegel, um ein Pegeldifferenzsignal zu erzeugen; und
Regeln der Verstärkung des Leistungsverstärkers als Antwort auf das Pegeldifferenzsignal.

## Revendications

1. Circuit de commande de puissance pour un amplificateur de puissance (1) ayant un niveau de sortie commandé par un signal de commande donné, comprenant :
un détecteur (11) pour détecter une sortie en provenance dudit amplificateur de puissance ;
un amplificateur à gain variable (3) pour amplifier un signal de sortie en provenance dudit détecteur ; et
une unité arithmétique (7) pour recevoir un signal de sortie en provenance dudit amplificateur à gain variable et une tension de référence prédéterminée, en tant qu'entrées, et pour délivrer un signal, représentant une différence entre le signal de sortie et la tension de référence, audit amplificateur de puissance, en tant que signal de commande.

2. Circuit selon la revendication 1, dans lequel ledit amplificateur de puissance comprend un module de puissance.

3. Circuit selon la revendication 1, dans lequel ledit amplificateur à gain variable modifie un gain de ce dernier sur la base du signal de commande donné.

4. Montage amplificateur comprenant :
des moyens formant amplificateur de puissance (1) pour amplifier un signal d'émission et pour modifier le niveau de sortie de ce dernier en réponse à un premier signal de commande ;
des moyens (11) pour détecter le niveau de sortie desdits moyens formant amplificateur pour produire un signal de détection ;
des moyens formant amplificateur variable (3) pour amplifier ledit signal de détection et pour modifier le niveau de sortie de ce dernier en réponse à un second signal de commande ; et
des moyens (7) pour comparer le niveau de sortie desdits moyens formant amplificateur variable à une tension de référence pour produire un signal de comparaison représentatif d'une différence de niveau entre eux et pour délivrer ledit signal de comparaison auxdits moyens formant amplificateur de puissance, en tant que dit premier signal de commande.

5. Procédé de commande d'un niveau de sortie d'un amplificateur de puissance, comprenant les étapes de :
détection dudit niveau de sortie pour produire un signal de détection ;
modification du niveau dudit signal de détection en réponse à un signal de commande de gain ;
comparaison du niveau modifié à un niveau de référence pour produire un signal de différence de niveau ; et
commande du gain dudit amplificateur de puissance en réponse audit signal de différence de niveau.
